# FASCICULE DE BREVET EUROPEEN

(11) **EP 0 531 185 B1**
(45) Date de publication et mention de la délivrance du brevet: **12.04.1995**
(21) Numéro de dépôt: 92402275.9
(22) Date de dépôt: 12.08.1992
(51) Int. Cl.: B60Q 1/26, F21Q 1/00, H05K 1/00, H01L 25/075

(54) **Elément de support, notamment pour feu de signalisation de véhicule automobile et son procédé de fabrication**
Trägerteil, insbesondere für Kfz-Signalleuchte, und sein Herstellungsverfahren
Supporting structure, especially for signalling lights of motor vehicles, and its manufacturing process

(30) Priorité: 02.09.1991 FR 9110837
(43) Date de publication de la demande: 10.03.1993
(73) Titulaire: VALEO VISION, 93012 Bobigny Cédex (FR)
(72) Inventeur: Segaud, Daniel, F-75012 Paris (FR)
(74) Mandataire: Lemaire, Marc

(56) Documents cités:
- FR-A- 2 106 074
- FR-A- 2 601 486
- US-A- 4 984 057

## Description

La présente invention concerne d'une manière générale un élément de support équipé d'un circuit électronique à composants multiples, notamment pour feu de signalisation de véhicule automobile.

Elle concerne également un procédé de fabrication d'un tel élément. Un tel élément équipe notamment les feux de signalisation de nouvelle génération pour véhicule automobile.

Ainsi qu'on le sait un feu de signalisation de conception classique se présente sous la forme d'un bloc comprenant au moins un réflecteur, dans lequel est montée une lampe à incandescence ou fluorescence, une glace transparente ou globe étant montée dans le réflecteur.

Un tel feu est relativement épais et pose des problèmes d'adaptation au support sur lequel il doit être monté, notamment la région du coin du véhicule ou une aile de celui-ci. D'une manière générale les ampoules sont fragiles, ont une durée de vie relativement courte et sont consommatrices d'énergie.

Pour cette raison on a déjà proposé de réaliser des feux de signalisation compacts en utilisant comme source lumineuse un ensemble d'émetteur de lumière à semi-conducteur, tel que des diodes électroluminescentes.

Ces réalisations permettent de pallier les inconvénients précités des feux classiques et offrent la possibilité de disposer, par exemple, des diodes éclairantes dans les deux couleurs, rouge et orange, utilisées pour la signalisation automobile, tout en étant incolores à l'état éteint, ce qui permet d'obtenir un feu d'aspect régulier.

Un tel feu est décrit par exemple dans le document FR-A-2 574 616 (US-A-4 742 432).

Dans celui-ci les diodes électroluminescentes sont montées sur un élément de support plan revêtu par un circuit électronique à composants multiples, un élément optique de collimation étant monté sur lesdites diodes. En pratique cet élément optique de collimation présente une pluralité de cavités paraboliques réfléchissantes se prolongeant par des ouvertures cylindriques isolantes venant s'engager à faible jeu dans des rondelles conductrices appartenant aux diodes, jusqu'à ce que la face inférieure isolante dudit élément optique vienne en butée sur le support.

Lorsque le feu est de forme gauche non plane, il faut conformer en conséquence ledit élément de collimation.

Un problème se pose alors car l'élément de support équipé de son circuit électronique à composants multiples ne peut plus s'adapter aisément à la forme dudit élément de collimation, ces composants étant disposés suivant un réseau tridimensionnel de composants dû à la forme gauche de l'élément de support.

La présente invention a pour objet de pallier cet inconvénient.

Suivant l'invention, un élément du type précité est caractérisé en ce qu'il comporte des lanières séparées les unes des autres par des fentes et en ce qu'une pluralité desdits composants multiples est montée sur chacune desdites lanières. Dans une forme de réalisation cet élément de support a globalement la forme d'un peigne avec des lanières séparées les unes des autres par des fentes. Les lanières se raccordent donc à une racine commune.

Selon un aspect particulier de l'invention, les composants électroniques comprennent des diodes électroluminescentes.

Un tel élément de support selon l'invention présente l'avantage de pouvoir prendre la forme d'une surface quelconque, y compris d'une surface présentant des courbures dans des directions différentes.

Le procédé de fabrication d'un tel élément est caractérisé en ce que, partant d'un élément de support plan équipé de son circuit électronique à composants multiples, on refend de multiples fois sur une partie de sa longueur ledit élément, de manière à constituer des lanières restant attachées par au moins une de leurs extrémités à une racine dudit élément.

Dans une deuxième étape, on déforme de manière permanente les lanières pour que, une fois mise en forme, elles s'alignent selon une courbe définie sur l'élément gauche associé audit élément de support. Dans une variante, partant d'un élément de support ayant au moins une portion en forme de peigne, dans une deuxième étape on déforme de manière permanente les lanières, dont la longueur a été calculée pour que, une fois mise en forme, elles s'alignent selon une courbe définie sur la surface gauche.

Grâce à la présente invention, on conserve un mode de montage de composants simples à plat pour réaliser un circuit tridimensionnel.

Dans le cas d'un feu de signalisation pour véhicule automobile, on équipe ledit élément de support de sources lumineuses discrètes, lesdites sources étant installées dans des zones de départ destinées à devenir des lanières ainsi que dans leur prolongement, c'est-à-dire dans la racine de l'élément de support.

Grâce à cette disposition il y a une unicité de technologie de montage de composants additionnels intégrés dans le feu pour obtenir des fonctionnalités telles que multiplexage de la commande d'allumage du feu, affichage de signe ou texte par allumage convenable des sources lumineuses discrètes.

On appréciera qu'il y a compatibilité avec l'utilisation de substrats métalliques comme support primaire, autorisant les transferts thermiques nécessaires au bon fonctionnement de l'électronique.

L'invention permet également une bonne aptitude au positionnement des sources lumineuses avec la précision requise par leur alignement optique vis-à-vis de l'enveloppe externe du feu de signalisation.

La position desdites sources lumineuses peut être calculée par ordinateur avec indexage physique au moyen de crans, d'encoches ou autres réalisés le long des lanières.

On appréciera que les sources lumineuses peuvent être prises en sandwich entre l'élément de support et son élément de forme gauche associé, tel que l'élément optique de collimation associé.

On appréciera également que la disposition selon l'invention est d'un emploi universel, les lanières pouvant être disposées horizontalement, verticalement, par exemple dans le cas de véhicule breack ou station wagon, obliquement.

Avantageusement, l'élément optique de collimation peut présenter en regard des lanières, des bandes, lesdites bandes étant alors disposées horizontalement, verticalement ou obliquement comme les lanières.

Grâce à cette disposition, ledit élément optique peut être robuste et de fabrication simple, et les diodes électroluminescentes peuvent se placer au foyer optique ou centre optique des ouvertures, que présente ledit élément optique.

La largeur des lanières peut être constante, ou évolutive d'une extrémité à l'autre ou évolutive d'une lanière à l'autre.

La forme des bords des lanières peut être réalisée avec ou sans aide de centrage optique.

La position de la racine de l'élément de support peut être située à une extrémité au centre ou décentrée. Dans ce dernier cas les lanières peuvent s'étendre dans deux directions. Il est possible également de prévoir plus de deux racines.

Cette disposition permet également le montage d'une variété de composants, à savoir, les sources lumineuses discrètes à résistances ohmiques et/ou des composants de puissance des éléments de connectique des microprocesseurs, des composants émetteur et/ou récepteur de rayonnement infrarouge.

La nature de l'élément de support peut être quelconque, à savoir, matière plastique isolante, substrat métallique isolé.

Le circuit électronique peut comporter un circuit imprimé rigide ou semi-rigide.

Le procédé de découpe des lanières peut être du type mécanique (sciage) ou réalisé à l'aide d'un laser ou par massicotage ou par découpe à l'emporte-pièce.

La description qui va suivre illustre l'invention, dans le cadre d'un feu de signalisation pour véhicule automobile, en regard des dessins annexés dans lesquels:
- la figure 1 est une vue frontale schématique de l'élément optique de collimation associé à l'élément de support selon l'invention;
- la figure 2 est une vue schématique de l'élément de support équipé après découpe de ses lanières;
- la figure 3 est une vue analogue à la figure 2, après déformation permanente des lanières;
- la figure 4 est une vue en coupe selon la ligne 4-4 de la figure 1;
- la figure 5 est une vue en coupe schématique selon ligne 5-5 de la figure 1;
- la figure 6 est une vue selon la flèche 6 de la figure 2 montrant une diode électroluminescente;
- la figure 7 est une variante de réalisation de la figure 2.

Dans ces figures, est illustré un élément de support 4 équipé d'un circuit électronique à composants multiples 2,3 pour feu de signalisation, de véhicule automobile, de forme non plane et gauche selon l'invention.

Cet élément de support 4 porte des sources lumineuses 3 discrètes sous la forme d'éléments électroluminescents discrets ou éléments optoélectroniques discrets. Ces éléments électroluminescents seront appelés par la suite diodes électroluminescentes.

De même, par élément de support ou support isolant, on entend une pièce en un matériau électriquement isolant tels que les éléments 1,4 et le support 6 décrits ci-après.

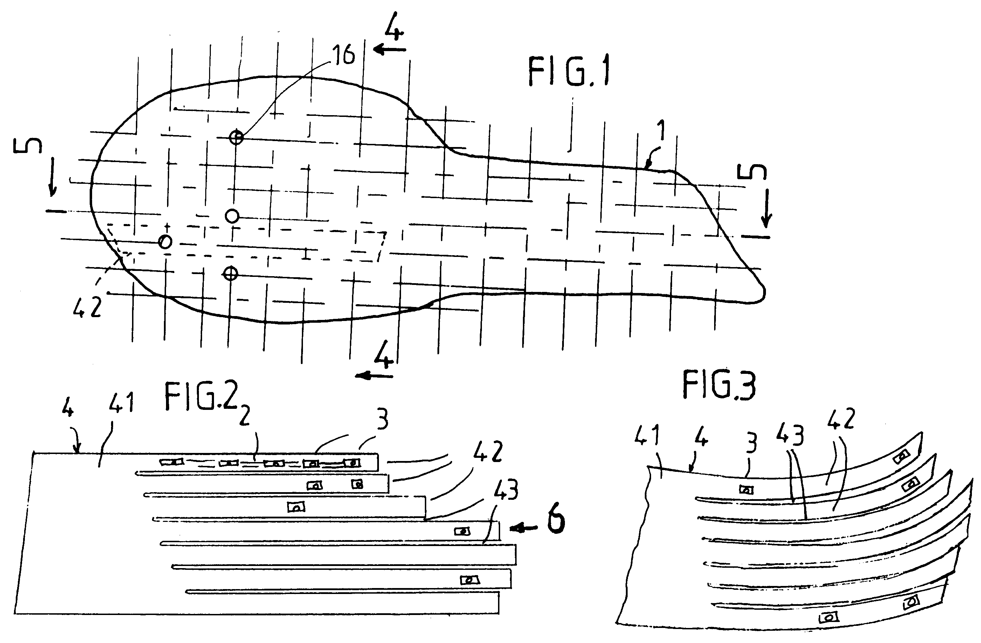

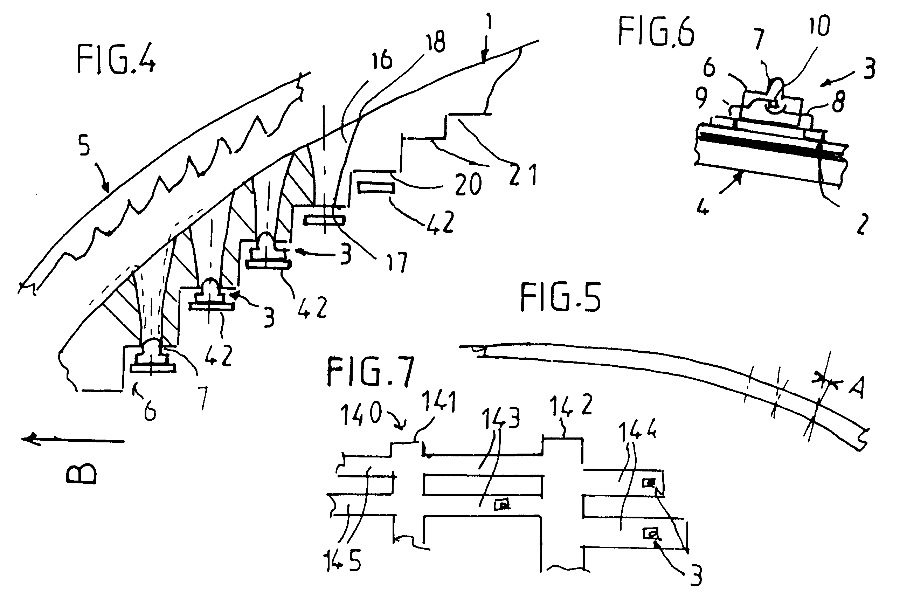

Comme visible à la figure 1 du document FR-A-2 481 563, et à la figure 6 de la présente demande, chaque diode électroluminescente 3 comporte un support 6 portant des bornes d'alimentation électriques 8,9, un émetteur de lumière proprement dit à semi-conducteur 10 et un encapsulage 7 saillant, à tête pénétrante, entourant ledit émetteur de lumière 10. Ici l'une des bornes d'alimentation, à savoir la borne 8, est une cathode présentant un réflecteur entourant le cristal 10, tandis que l'autre borne d'alimentation 9 est une anode. Ces bornes 8,9 sont ici en majeure partie noyées dans le support 6, ici isolant électriquement.

Un élément de collimation 1, ici en matière électriquement isolante, est associé à l'élément de support 4 et a comme celui-ci une forme gauche, lesdits éléments 1,4 ayant une forme s'adaptant l'un à l'autre. Cet élément de collimation 1 présente en regard de chaque encapsulage 7 une ouverture 16 traversante avec formation d'un réseau tridimensionnel de diodes 3 et d'ouvertures 16.

Un circuit électrique 2 est prévu pour alimentation électrique et interconnexion des bornes d'alimentation 8,9 et donc des diodes 3. Ce circuit électrique 2 appartient au circuit électronique porté par l'élément de support 4, plus précisément par la face frontale de celui-ci tournée vers l'élément de collimation 1.

L'élément de support 4, avantageusement en matériau électriquement isolant, est donc revêtu par le circuit électrique 2 réalisé par exemple par sérigraphie (dépôt d'encre conductrice sur la face frontale de l'élément 4) ou en variante par dépôt électrochimique ou électrolytique.

On peut également réaliser, comme décrit dans le document FR-A-2 601 486 (EP-A-0 253 244), le circuit électrique à l'aide d'un film souple rapporté par collage sur la face frontale de l'élément 4 au moyen d'une pellicule adhésive, ledit film portant un revêtement cuivré et étamé.

Une telle disposition est visible à la figure 6, la pellicule adhésive étant représentée en sombre.

Suivant l'invention, un élément de support 4 équipé d'un circuit électronique à composants multiples 2,3 du type sus-indiqué est caractérisé en ce qu'il comporte des lanières 42 séparées les unes des autres, et en ce que sur chacune desdites lanières 42 est montée une pluralité de composants électroniques tels que, au moins pour une partie d'entre eux, des diodes électroluminescentes 3.

Dans le mode de réalisation de la figure 2, l'élément de support 4 équipé a globalement la forme d'un peigne avec des lanières 42 séparées les unes des autres par des fentes 43. Ces lanières 42 se raccordent à une racine commune 41, que présente ledit élément de support 4 équipé à l'une de ses extrémités.

Le procédé de fabrication d'un tel élément de support est caractérisé en ce que, partant d'un élément de support 4 équipé de son circuit électronique à composants multiples 2,3, on refend de multiples fois sur une partie de sa longueur ledit élément 4, de manière à constituer des lanières 42 restant attachées par au moins une de leurs extrémités à une racine 41 dudit élément.

A la figure 2, les lanières 42 sont attachées à l'une de leurs extrémités à la racine 41, tandis que l'autre de leurs extrémités est libre.

Ainsi dans une deuxième étape on déforme de manière permanente les lanières 42 dont la longueur a été calculée pour que, une fois mise en forme, elles s'alignent selon une courbe définie sur leur surface gauche associée, ici des bandes 20 décrites ci-après de l'élément 1.

Ici les fentes 43 et les lanières 42 sont réalisées par sciage mécanique ou à l'aide d'un procédé laser ou par massicotage ou par découpe à l'emporte-pièce.

L'élément de collimation 1 présente, suivant une caractéristique, des bandes 20 pour s'adapter aux lanières 42. La largeur des bandes est donc adaptée à la largeur des lanières 42, la largeur des bandes 20 étant ici supérieure à la largeur des lanières 42. Ainsi la face dorsale, tournée vers l'élément 4 et vers les lanières 42 (figure 4) de cet élément de collimation 1 est conformée en gradins 21. Les bandes 20 servent donc au support des diodes 3 en constituant la partie horizontale de gradins 21, en référence à la figure 4.

Les bandes 20 appartiennent donc aux gradins 21 et constituent la partie horizontale de ceux-ci (figure 4). Ces bandes sont séparées par des parois verticales et forment donc des ressauts.

L'élément 1 a donc une fonction optique et mécanique en étant robuste.

Les ouvertures 16 débouchent dans ces bandes 20. Ici les ouvertures 16 sont traversantes et leur extrémité dorsale 17 dépend de la taille de l'encapsulage 7. Ledit encapsulage pouvant être monté à jeu ou sans jeu dans ladite ouverture évasée 16. Ces ouvertures 16 présentent une extrémité frontale 18 de taille supérieure à celle de l'extrémité dorsale 17.

On appréciera que l'extrémité dorsale 17 de l'ouverture 16 est associée à chaque encapsulage 7 en sorte que l'on peut monter aisément l'encapsulage 7 dans l'ouverture 16 sans être gêné. Ici cet encapsulage 7 à forme pénétrante a globalement la forme d'une ogive, mais bien entendu elle pourrait être en forme de demi-olive ou autre. La forme de sa tête étant telle qu'elle permet un montage aisé et un centrage dans l'ouverture 16 associée.

L'encapsulage 7 s'érige en saillie à partir de la face frontale du support 6 par exemple de forme cylindrique ou rectangulaire.

Les diodes 3 ont donc une structure compacte et économique, la largeur des lanières 42 étant adaptée à la dimension des diodes et autres composants électroniques portés par l'élément de support 4. Les diodes 3 ou autres composants électroniques étant installés dans des zones destinées dès le départ à devenir des lanières.

Le circuit 2 est donc à l'image de l'élément de support 4 et présente des lanières.

La fixation des éléments 3 se fait par exemple par soudage par exemple dans un four à refusion ou par soudage à la vague. On peut également procéder à la fixation à l'aide d'une porte collante conductrice qui se polymérise par la suite. Tout autre mode de fixation est envisageable, tel que chauffage par induction ou chauffage par micro-onde, car, grâce à l'invention, tous les composants électroniques se montent aisément en surface lorsque l'élément de support 4 est plan avant sa déformation.

On notera que l'élément de support 4 est isolant et qu'il est par exemple en matière plastique.

D'une manière générale ce support 4 est semi-rigide. Bien entendu, l'élément de support 4 peut être un substrat métallique isolé. Cet élément 4 est propre à être fixé à la carrosserie du véhicule automobile, soit directement ou soit indirectement.

L'élément optique de collimation est robuste et est en matière isolante et a donc une forme gauche avec une multitude d'ouvertures 16 dont on voit à la figure 1 les axes de symétrie.

L'élément 1 ici bombé présente une face frontale revêtue d'un revêtement réfléchissant 12 ainsi qu'un alésage interne des ouvertures 16.

Le revêtement 12 est avantageusement à base d'aluminium. Cet élément 1 est opaque et est réalisé avantageusement en matière plastique. Cet élément 1 consiste donc en un réflecteur conformé en guide de lumière avec des faces dorsales et frontales spécialisées, la face frontale ayant une fonction optique, tandis que la face dorsale a une fonction mécanique de support.

Ici les bandes 20 ont une surface de forme cylindrique et elles s'étendent toutes parallèlement en section dans une direction commune B (voir figure 4).

Les lanières 42 ont donc ici également une forme cylindrique après leur déformation à l'aide d'un outil approprié, lorsque l'élément de support 4 est souple, ou à l'aide de l'élément optique de collimation 1, lorsque l'élément de support 4 est semi-rigide.

On appréciera que la fabrication de l'élément 1 est aisée, le démoulage des ouvertures 16 ne posant aucun problème, lesdites ouvertures 16 étant de forme évasée telle qu'une conique de révolution; une conique étant une surface correspondant au lieu géométrique des points dont le rapport des distances à un point fixe dit foyer et à une droite dite directrice, a une valeur donnée. Ces ouvertures forment un réseau tridimensionnel d'ouvertures, tout comme le réseau de diodes.

La taille de l'extrémité frontale 18 des ouvertures 16 varie selon leur position sur le feu. Bien entendu on peut espacer plus ou moins les ouvertures 16 en fonction de leur position sur le feu pour avoir le meilleur rendement optique.

Comme visible à la figure 5, les axes des ouvertures 16 peuvent être inclinés d'un angle A selon leur position sur le feu.

Les diodes 3 forment globalement une matrice de diodes telle que visible à la figure 1.

Les diodes 3 peuvent émettre en couleur rouge ou en couleur orange, le transparent 5 pouvant être teinté ou présenter des couleurs ambres ou rouges selon les desiderata des constructeurs.

Le circuit électronique selon l'invention peut comporter également des composants de puissance, des éléments de connectique, des microprocesseurs, des composants émetteur et/ou récepteur de rayonnement infrarouge.

Ainsi il est possible de réaliser un multiplexage de la commande d'allumage des feux, un affichage de signe de texte par l'allumage convenable des diodes 3.

Ainsi qu'on l'aura compris et qu'il ressort à l'évidence de la description et des dessins, les diodes 3 viennent se placer exactement au foyer des ouvertures 16, en sorte que le feu selon l'invention a de grandes performances optiques. Les diodes 3 étant prises en sandwich après déformation des lanières 42, entre les lanières 42 et les bandes 20 de l'élément optique de collimation.

Ici cet élément optique est revêtu par un élément transparent 5 qui peut être de couleur fumée ou être de plusieurs couleurs, par exemple ambre et rouge selon les souhaits du constructeurs.

Bien entendu la présente invention n'est pas limitée à l'exemple de réalisation décrit. En particulier les lanières 42 peuvent s'étendre dans les deux sens par rapport à la racine 41 dont la position peut dépendre des applications. Ici la racine 41 est disposée à l'extrémité du support 4, mais bien entendu elle peut être disposée au milieu de celui-ci.

Bien entendu, l'élément de support peut être doté de plusieurs racines. Ainsi par exemple, tel que représenté à la figure 7, l'élément 140 peut présenter deux racines 141,142 avec trois jeux de lanières 145,143,144. Les lanières 143 s'étendent entre les deux racines 142, tandis que les lanières 144 et 145 ont des extrémités libres et s'étendent en porte-à-faux par rapport aux racines 142,141.

Bien entendu, la longueur des lanières et des racines est calculée pour que, une fois mise en forme, elles s'alignent selon une courbe définie sur leur surface gauche associée, notamment des bandes 20.

Tout ceci dépend de la forme du feu. La largeur des lanières pouvant être évolutive de même que leur longueur (voir par exemple les lanières 144 de la figure 7). La largeur peut varier d'une lanière à l'autre. Il en est de même de leur longueur qui est adaptée à la forme du feu.

L'élément optique de collimation 1 peut avoir une forme gauche quelconque et être dépourvu intérieurement de gradin pour appui des diodes 3.

Les bandes 20 et les lanières 42 peuvent s'étendre horizontalement comme à la figure 1, ou verticalement ou obliquement.

L'élément optique 1 peut servir à la fixation du feu sur la carrosserie du véhicule automobile. Il peut être par exemple de forme creuse en étant pourvu sur sa face dorsale d'un rebord périphérique enveloppant l'élément de support 4 en étant pourvu de moyens de fixation sur la carrosserie du véhicule.

Dans ce cas, l'élément de support 4 est fixé par sa ou ses racines 41-141,142 audit élément optique 1.

Bien entendu, l'élément de support 4 peut être également de forme creuse en ayant sur sa face dorsale un rebord pour la fixation du feu à la carrosserie du véhicule. Dans ce cas, son fond est fractionné en lanières entouré par ledit rebord de fixation.

L'élément optique de collimation vient alors se fixer sur ledit élément 4 (à la faveur dudit rebord de fixation), ainsi que le transparent.

Ainsi qu'il ressort à l'évidence de la description et des dessins, l'élément de support 4 est avantageusement en matériau semi-ridige. Dans ce cas, l'élément optique de collimation 1 constitue un gabarit pour ledit élément 4, les lanières 42 se déformant et épousant la forme des bandes 20 automatiquement par coopération des diodes 3 avec les bandes 20.

Bien entendu, l'élément de support 4 peut être en matériau plus souple et dans ce cas il faut un gabarit spécifique pour le conformer.

## Revendications

1. Elément de support équipé d'un circuit électronique à composants multiples, notamment pour feu de signalisation automobile, caractérisé en ce qu'il comporte des lanières (42) séparées les unes des autres par des fentes (43) et en ce qu'une pluralité desdits composants multiples (3) est montée sur chacune desdites lanières (42).

2. Elément de support selon la revendication 1, caractérisé en ce que lesdits composants (3) comprennent des diodes électroluminescentes (3).

3. Elément de support selon la revendication 1 ou 2, caractérisé en ce qu'il comporte au moins une portion en forme de peigne.

4. Elément de support selon la revendication 3, caractérisé en ce que ladite portion comporte des lanières (42) qui se raccordent à au moins une racine (41) dudit élément de support (4).

5. Elément de support selon l'une quelconque des revendications 1 à 4, caractérisé en ce que la largeur des lanières (42) est évolutive d'une de leurs extrémités à l'autre.

6. Elément de support selon l'une quelconque des revendications 1 à 5, caractérisé en ce que la largeur des lanières (42) est évolutive d'une lanière (42) à l'autre.

7. Procédé de fabrication d'un élément de support selon l'une quelconque des revendications précédentes, caractérisé en ce que, partant d'un élément de support plan équipé de son circuit électronique à composants multiples (3), on refend de multiples fois sur une partie de sa longueur ledit élément de support (4), de manière à constituer des lanières (42) restant attachées par au moins une de leurs extrémités à une racine (41,141) dudit élément.

8. Procédé de fabrication selon la revendication 7, caractérisé en ce que dans une deuxième étape on déforme de manière permanente les lanières (42).

## Claims

1. A support element carrying a multiple-component electronic circuit, in particular for a motor vehicle signal lamp, characterised in that it includes strips (42) separated from each other by slots (43), and in that a plurality of the said multiple components (3) are mounted on each of the said strips (42).

2. A support element according to Claim 1, characterised in that the said components (3) comprise light-emitting diodes (3).

3. A support element according to Claim 1 or Claim 2, characterised in that it includes at least one comb-shaped portion.

4. A support element according to Claim 3, characterised in that the said portion includes strips (42) which are joined to at least one root portion (41) of the said support element (4).

5. A support element according to any one of Claims 1 to 4, characterised in that the width of the strips (42) changes from one of their ends to the other.

6. A support element according to any one of Claims 1 to 5, characterised in that the width of the strips (42) changes from one strip (42) to another.

7. A method of manufacture of a support element in accordance with any one of the preceding Claims, characterised in that, starting with a flat support element equipped with its electronic circuit having multiple components (3), the said support element (4) is cut a multiplicity of times over part of its length, so as to form strips (42) which remain attached by at least one of their ends to a root portion (41, 141) of the said element.

8. A method of manufacture according to Claim 7, characterised in that, in a second step, the strips (42) are permanently deformed.

## Patentansprüche

1. Trägerelement, bestückt mit einer elektronischen Schaltung mit Mehrfach-Bauelementen, insbesondere für Kraftfahrzeug-Signalleuchten , **dadurch gekennzeichnet,** daß es Streifen (42) umfaßt, die durch Schlitze (43) voneinander getrennt sind, und daß eine Mehrzahl der genannten Mehrfach-Bauelemente (3) auf jedem der genannten Streifen (42) angebracht ist.

2. Trägerelement nach Anspruch 1, **dadurch gekennzeichnet,** daß die genannten Bauelemente (3) Lumineszenzdioden (3) umfassen.

3. Trägerelement nach Anspruch 1 oder 2, **dadurch gekennzeichnet,** daß es mindestens einen kammförmigen Abschnitt umfaßt.

4. Trägerelement nach Anspruch 3, **dadurch gekennzeichnet,** daß der genannte Abschnitt Streifen (42) umfaßt, die sich an mindestens eine Wurzel (41) des genannten Trägerelements (4) anschließen.

5. Tragerelement nach einem der Ansprüche 1 bis 4, **dadurch gekennzeichnet,** daß die Breite der Streifen (42) von einem ihrer Enden zum anderen veränderlich ist.

6. Trägerelement nach einem der Ansprüche 1 bis 5, **dadurch gekennzeichnet,** daß die Breite der Streifen (42) von einem Streifen (42) zum anderen veränderlich ist.

7. Verfahren zur Herstellung eines Trägerelements nach einem der vorangehenden Ansprüche , **dadurch gekennzeichnet,** daß ausgehend von einem ebenen Trägerelement, das mit seiner elektronischen Schaltung mit Mehrfach-Bauelementen (3) bestückt ist, das genannte Trägerelement (4) mehrfach auf einem Teil seiner Länge längsgeteilt wird, um Streifen (42) zu bilden, die zumindest mit einem ihrer Enden an einer Wurzel (41, 141) des genannten Trägerelements angefügt bleiben.

8. Herstellungsverfahren nach Anspruch 7, **dadurch gekennzeichnet,** daß die Streifen (42) in einem zweiten Schritt bleibend verformt werden.
